# EUROPEAN PATENT APPLICATION

(11) **EP 1 308 993 A2**
(43) Date of publication of application: **07.05.2003**
(21) Application number: 02024051.1
(22) Date of filing: 28.10.2002
(51) Int. Cl.: H01L 21/28, H01L 29/78

(54) **High-K gate oxides with buffer layers of titanium for mfos single transistor memory applications**

(30) Priority: 30.10.2001 US 15817
(71) Applicant: Sharp Kabushiki Kaisha, Osaka-shi, Osaka 545-8522 (JP)
(72) Inventor: Li, Tingkai, Vancouver, WA 98683 (US); Hsu, Sheng Teng, Camas, WA 98607 (US); Ulrich, Bruce Dale, Beaverton, OR 97008 (US); Horn Stecker, Lisa, Vancouver, WA 98683 (US)
(74) Representative: Müller - Hoffmann & Partner

(57) **Abstract**

A method of fabricating a memory device includes preparing a silicon substrate; depositing a layer of high-k insulator on the silicon substrate; depositing a buffering layer on the high-k insulating layer; depositing a layer of ferroelectric material on the buffering layer by metal organic chemical vapor deposition; forming a top electrode on the layer of ferroelectric material; and completing the device obtained by above steps.

## Description

### Related Applications

This application is related to: "Chemical Vapor Deposition of Pb₅Ge₃O₁₁ Thin Film for Ferroelectric Applications," U. S. Patent No. 6,242,771, granted June 5,2001; "A Method and System for Metalorganic Chemical Vapor Deposition (MOCVD) and Annealing for Lead Germinate (PGO) Thin Films," Serial No. 09/489,857, filed January 24, 2000; and "C-axis Oriented Lead Germinate Film and Deposition Method," U. S. Patent No. , granted .

### Field of the Invention

This invention relates to single transistor memory structures and integrated fabrication techniques for ferroelectric non-volatile memory devices.

### Background of the Invention

Metal, ferroelectric, oxide, and silicon (MFOS) one-transistor (IT) memory devices have been proposed. In order to obtain good semi-conductor properties in MFOS IT devices, the oxide should have no reaction with, and no diffusion into, the ferroelectric material or silicon substrate. The ferroelectric thin film deposited on the oxide should have a low dielectric constant, a small polarization value (Pr) and good ferroelectric properties to provide a high quality memory transistor. Based on these requirements, Pt/PGO/Gate oxide/Si (MFOS) is selected as the preferred structure for a one transistor memory device. However, c-axis oriented PGO (Lead Germanium Oxide (Pb₅Ge₃O₁₁)) thin films having good ferroelectric properties are difficult to deposit on gate oxides because of an interface mismatch. In order to solve this problem, a buffer layer between PGO thin films and the gate oxide is used.

C. J. Peng, *et al*., *Oriented lead germinate thin films by excimer laser ablation,* describes early work in the field of excimer laser ablation of ferroelectric thin films. Appl. Phys. Lett. Vol. 60, pp. 827-829 (1992).

J. J. Lee, *et al*., *Processing of a uniaxial ferroelectric Pb*_{*5*}*Ge*_{*3*}*O*_{*11*} *thin film at 450°C with c-axis orientation,* describes fabrication of lead germinate thin films by a sol-gel process, which produced crack-free, c-axis oriented thin films. Appl. Phys. Lett. Vol. 60, pp. 2487-2488 (1992).

H. Schmitt, *et al*., *Properties of undoped and doped ferroelectric lead germinate thin films*, describes reactive sputtering techniques to fabricate a lead germinate thin film. Ferroelectrics, Vol. 56, pp. 141-144 (1984).

S. B. Krupanidhi, *et al*., *Pulsed excimer laser deposition of ferroelectric thin films,* describes pulsed UV excimer laser ablation of PZT, bismuth titanate and lead germinate. Proceedings of 3rd International Symp. on Integrated Ferroelectrics, pp. 100-115 (1991).

### Summary of the Invention

A method of fabricating a memory device includes preparing a silicon substrate; depositing a layer of high-k insulator on the silicon substrate; depositing a buffering layer on the high-k insulating layer; depositing a layer of ferroelectric material on the buffering layer by metal organic chemical vapor deposition; forming a top electrode on the layer of ferroelectric material; and completing the device obtained by above steps.

It is an object of the invention to provide a method of fabricating a MFOS one-transistor memory device.

Another object of the invention is to fabricate a MFOS memory device having a high-k and buffer layer sandwich between the substrate and the ferroelectric to prevent degradation of ferroelectric properties.

A further object of the invention is to use a metal organic chemical vapor deposition (MOCVD) technique to fabricate a high c-axis oriented PGO thin film for deposition on a layer of high-k material, such as ZrO₂, HfO₂ and (Zrₓ,Hf₁₋ₓ)O₂, using a titanium buffer layer, for use in a PGO MFOS IT memory application.

This summary and objectives of the invention are provided to enable quick comprehension of the nature of the invention. A more thorough understanding of the invention may be obtained by reference to the following detailed description of the preferred embodiment of the invention in connection with the drawings.

### Brief Description of the Drawings

Fig. 1 depicts an X-ray pattern of PGO thin films deposited on titanium /ZrO₂ using an *in situ* oxidation annealing process.

Fig. 2 depicts an X-ray patterns of PGO thin films deposited on titanium /HfO₂ using an *in situ* oxidation annealing processes.

Fig. 3 is the memory window of AGO MFOS structure on a titanium/ZrO₂ layer.

Fig. 4 is the memory window of PGO MFOS structure on a titanium/HfO₂ layer.

Fig. 5 is the memory window of PGO MFOS memory cell with titanium/ZrO₂ after plasma etching of a top electrode.

Fig. 6 is the memory window of PGO patterned MFOS memory cell with titanium/ZrO₂ after conventional etching of a top electrode.

### Detailed Description of the Preferred Embodiment

In order to fabricate high quality PGO MFOS memory cells, lead germanium oxide (Pb₅Ge₃O₁₁) (PGO) thin films are deposited on high-k gate oxides, such as ZrO₂ and HfO₂, having a buffer layer of titanium or TiO₂. Such fabrication of high c-axis oriented PGO thin films on ZrO₂, HfO₂, or (Zrₓ,Hf₁₋ₓ)O₂, with a buffer layer of titanium or TiO₂, has been achieved by using optimized metal organic chemical vapor deposition (MOCVD) and a two step annealing processes in one-transistor memory applications. The memory windows of PGO MFOS with titanium/ZrO₂ and titanium/HfO₂ have been measured to be larger than 2.2 V and 3.5V, respectively, which windows are sufficient for IT memory applications. Plasma etching induced damage of PGO thin films formed on titanium/ZrO₂ and titanium/HfO₂ have been examined and minimized.

### The Method of the Invention

The method of the invention includes fabrication of a one-transistor ferroelectric memory devices having a PGO MFOS structure, including a high c-axis oriented PGO thin film formed on a layer of high-k gate oxides, such as ZrO₂ and HfO₂, wherein a buffer layer of titanium or TiO₂ is formed between the high-k layer and the PGO thin film. This insulating/buffering sandwich prevents incursion of the oxide into the ferroelectric or silicon substrate.

A P-type silicon wafer is used as the substrate for the MFOS one transistor memory application. The silicon wafer is prepared by cleaning using SC1 + SC2; where SC1 is a mixture of 5500 ml of deionized water, 1100 ml of NH₄OH and 1100 ml of H₂O₂, and where SC2 is a mixture of 6000 ml of deionized water, 1000 ml of HCl and 1000 ml of H₂O₂; and surface oxide is removed by HF dip etching. A layer of high-k material, such as ZrO₂, HfO₂ or (Zrₓ,Hf₁₋ₓ)O₂ thin film is sputtered on the silicon substrate to a thickness of between about 2 nm to 20 nm, and preferably to a thickness of between about 2 nm to 8 nm. The silicon wafer, with the high-k layer, is annealed at between about 500°C to 550°C in a pure oxygen atmosphere, for between about one minute and twenty minutes to achieve full oxidation. A buffer layer, such as titanium or TiO₂, is deposited on the high-k gate oxides by sputtering to a thickness of between about 2 nm to 10 nm.

An oxide MOCVD reactor is used to grow of c-axis oriented PGO thin film on the insulating/buffering sandwich layer to a thickness of between about 200 nm to 300 nm. A top electrode of Pt, having a thickness of about 100 nm, is deposited on the PGO thin film by electron beam evaporation. The memory device is then completed using conventional techniques.

The PGO thin film is deposited by MOCVD, using a PGO precursor formed by dissolving [Pb(thd)₂], where thd = C₁₁H₁₉O₂, and [Ge(ETO)₄], where ETO = OC₂H₅, having a molar ratio of 5.0 to 5.5:3, in a mixed solvent of butyl ether or tetrahydrofuran, isopropanol and tetraglyme, in a molar ratio of 8:2:1. The precursor solutions has a concentration of 0.1 mole/liter of PGO. The solution is injected into a vaporizer at a temperature of between about 150°C to 250°C, at a pump at a rate of 0.1 ml/min. to 0.2 ml/min, to form the precursor gas. The temperature of the growth line is between about 165°C to 245°C. The MOCVD is conducted at a deposition temperature of between about 350°C to 450°C, at a pressure of about 5 torr, and with an oxygen partial pressure of about 30 %. The annealing process conditions for c-axis oriented PGO thin films include processing at an annealing temperature of between about 500°C to 510°C for between about 5 minutes to 10 minute in an oxygen atmosphere, using a rapid thermal processing (RTP) technique for the first annealing step. The second annealing step is conducted at a temperature of between about 540°C to 600°C for between about 30 minutes to one hour, in an oxygen atmosphere, in either a RTP chamber, or in an annealing furnace.

The phases of the PGO thin films were identified using x-ray diffraction. The compositions of the Pb₅Ge₃O₁₁ films were analyzed using ultra high resolution X-ray photoelectron spectrometer (XPS). The capacitance of the PGO MFOS capacitors was measured using a Keithley 182 CV analyzer.

### The Results

C-axis oriented PGO thin films deposited on ZrO₂ and HfO₂, using conventional techniques, have always had second phase and random peaks, which results in poor ferroelectric properties. In order to deposit high c-axis oriented PGO thin film on high-k gate oxide for MFOS IT memory applications, PGO thin films were deposited on a high-k oxide layer with a buffer layer, such as titanium or TiO₂, according to the method of the invention. The method of the invention produces PGO thin films which are amorphous and which have c-axis orientation peaks appearing only after high temperature annealing. PGO thin films which were deposited on the buffer layer, with *in situ* oxidation, exhibit high c-axis orientation. The method of the invention using ZrO₂ or HfO₂, with a buffer layer of titanium, produce PGO MFOS devices suitable for memory applications. The optimum thickness for the titanium layer is between about 2 nm to 10 nm, and the optimum thickness for ZrO₂ or HfO₂ is between about 4 nm to 20 nm.

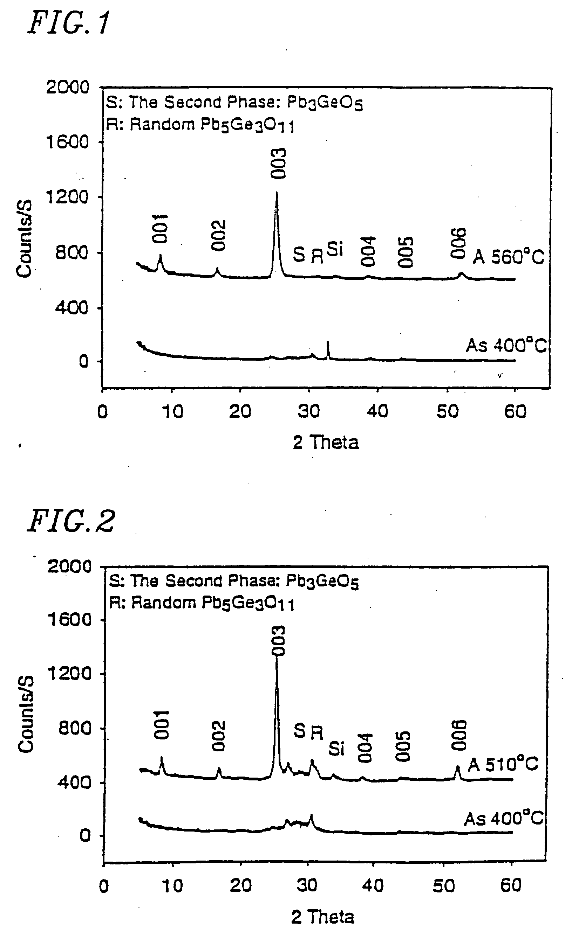

Figs. 1 and 2 depict the X-ray patterns of PGO thin films deposited on ZrO₂ and HfO₂, with a buffer layer of titanium, at various temperatures in accordance with the method of the invention. For the PGO thin films, the nucleation temperature of c-axis PGO thin film is about 500°C, and the grain growth temperature is greater than 540°C. Therefore, a two-step annealing process is used for growth of high c-axis oriented PGO thin films on a ZrO₂ or HfO₂ high-k layer, with a buffer layer of titanium formed on the high-k dielectric layer. In the first step, PGO c-axis phase nucleation occurs during annealing at about 510°C, and for c-axis phase grain growth, annealing at between about 540°C to 600°C. Using this technique, a strong c-axis oriented PGO thin film may be formed on the buffer layer of titanium overlying the high-k ZrO₂ or HfO₂ layer.

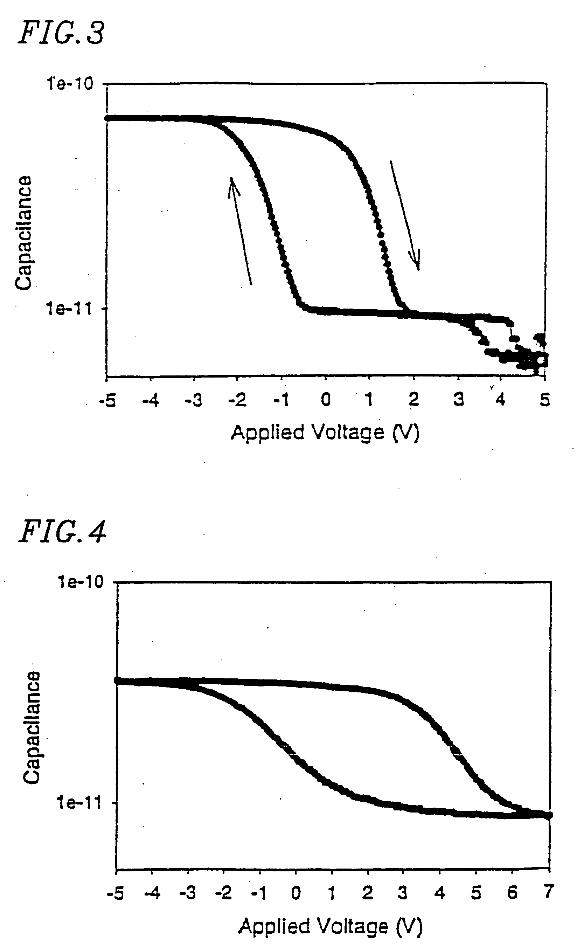

In order to determine the suitability of the method of the invention for fabricating a PGO MFOS IT memory device, PGO MFOSs were made, one with a titanium/ZrO₂ layer and one with a titanium/HfO₂ layer. Figs. 3 and 4 depict the memory windows of AGO MFOS structures with titanium/ZrO₂ and HfO₂, respectively. The memory windows of PGO MFOS with titanium/ZrO₂ and titanium/HfO₂ are 2.2 V and 3.5 V, respectively, which is sufficient for a IT-memory application.

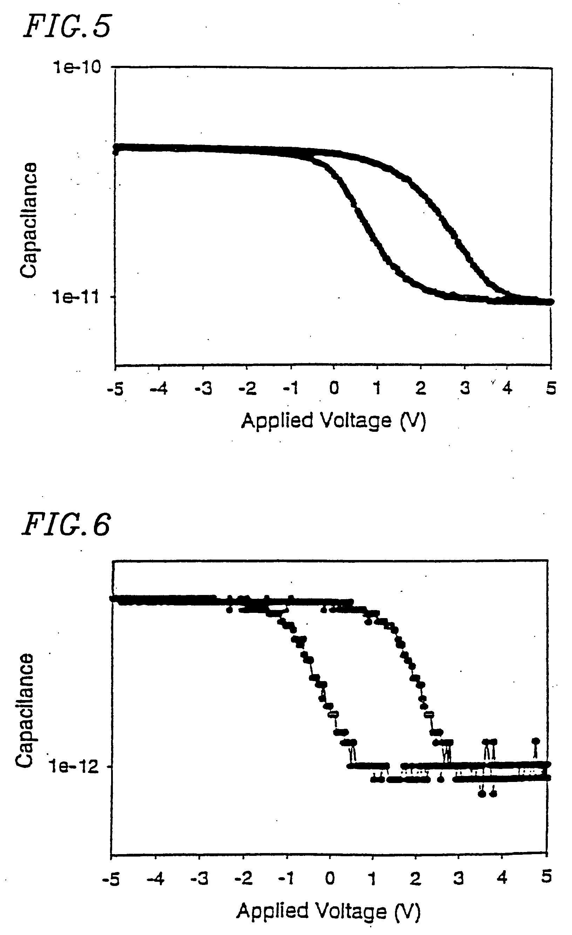

In order to determine the amount of plasma etch induced damage using the method of the invention, the top electrode of a PGO MFOS memory cell having a structure of Pt/PGO/titanium/ZrO₂/Si, was etched using a low power, conventional etch process; and a plasma etch process. Figs. 5 and 6 depict the measured memory window of PGO MFOS with titanium/ZrO₂ memory cell after plasma etching of the top electrode, and after conventional low power etching of the top electrode, respectively. The figures show that the memory window of PGO MFOS with titanium/ZrO₂ memory cell decreases from 2.2 V to 1.8 V after plasma etching of the Pt top electrode, which is still sufficient voltage for use as a IT memory device.

In summary, formation of high c-axis oriented PGO thin films on ZrO₂ and HfO₂, with a buffer layer of titanium or TiO₂, has been achieved by using optimized MOCVD and a novel two-step annealing processes for one-transistor memory applications; the memory windows of PGO MFOS with titanium/ZrO₂ and titanium/HfO₂ are measured larger than 2.2 V and 3.5V, which are sufficient for IT-memory applications; and the plasma etching and strip process induced damages of PGO thin films deposited on titanium/ZrO₂ and titanium/HfO₂ are reduced by the method of the invention.

Thus, a method for fabricating High-K gate oxides with buffer layers of titanium for MFOS single transistor memory applications has been disclosed. It will be appreciated that further variations and modifications thereof may be made within the scope of the invention as defined in the appended claims.

## Claims

1. A method of fabricating a memory device comprising the steps of:
a) preparing a silicon substrate;
b) depositing a layer of high-k insulator on the silicon substrate;
c) depositing a buffering layer on the high-k layer;
d) depositing a layer of ferroelectric material on the buffering layer by metal organic chernical vapor deposition;
e) forming a top electrode on the layer of ferroelectric material; and
f) completing the device obtained by the steps a) - e)

2. The method of claim 1 wherein said step a) of preparing the silicon substrate includes selecting a P-type silicon substrate wafer; cleaning the P-type silicon substrate wafer and removing surface oxide from the P-type silicon substrate wafer.

3. The method of claim 1 wherein said step b) of depositing a layer of high-k insulator on the silicon substrate includes selecting a high-k material from the group of materials consisting of ZrO₂, HfO₂ and (Zrₓ,Hf₁₋ₓ)O₂, depositing the high-k material on the silicon substrate to a thickness of between about 2 nm to 20 nm, and preferably to a thickness of between about 2 nm to 8 nm; and annealing the silicon substrate at between about 500°C to 550°C in a pure oxygen atmosphere, for between about one minute and twenty minutes.

4. The method of claim 1 wherein said step c) of depositing a layer of buffering metal includes selecting a buffering layer from the group of buffering layers consisting of titanium and TiO₂; and depositing the buffering layer to a thickness of between about 2 nm to 10 nm.

5. The method of claim 1 wherein said step d) of depositing a layer of ferroelectric material includes preparing a precursor for PGO by dissolving [Pb(thd)₂] and [Ge(ETO)₄], having a molar ratio of 5.0 to 5.5:3, in a mixed solvent of butyl ether or tetrahydrofuran, isopropanol and tetraglyme, in a molar ratio of 8:2:1, resulting in a precursor solutions concentration of 0.1 mole/liter of PGO.

6. The method of claim 5 wherein said step d) of depositing a layer of ferroelectric material further includes injecting the precursor solution into a vaporizer at a temperature of between about 150°C to 250°C, at a pump at a rate of between about 0.1 ml/min. to 0.2 ml/min, to form a precursor gas; and pumping the precursor gas into a CVD chamber at a deposition temperature of between about 350°C to 450°C, at a pressure of about 5 torr, and with an oxygen partial pressure of about 30 %.

7. The method of claim 6 wherein the silicon substrate with the ferroelectric material layer depositing thereon is annealed in a first annealing step at an annealing temperature of between about 500°C to 510°C for between about 5 minutes to 10 minute in an oxygen atmosphere, using a rapid thermal processing technique; and annealed in a second annealing step a temperature of between about 540°C to 600°C for between about 30 minutes to one hour, in an oxygen atmosphere.

8. A method of fabricating a PGO MFOS one-transistor memory device comprising:
a) preparing a silicon substrate;
b) depositing a layer of high-k insulator on the silicon substrate, including
b1) selecting a high-k material from the group of materials consisting of ZrO₂, HfO₂ and (Zrₓ,Hf₁₋ₓ)O₂,
b2) depositing the high-k material on the silicon substrate to a thickness of between about 2 nm to 20 nm, and preferably to a thickness of between about 2 nm to 8 nm; and
b3) annealing the silicon substrate at between about 500°C to 550°C in a pure oxygen atmosphere, for between about one minute and twenty minutes;
c) depositing a buffering layer on the high-k insulating layer, including selecting a buffering layer from the group of buffering layers consisting of titanium and TiO₂; and depositing the buffering layer to a thickness of between about 2 nm to 10 nm;
d) depositing a layer of ferroelectric material on the buffering layer by metal organic chernical vapor deposition;
e) forming a top electrode on the layer of ferroelectric material; and
f) completing the device obtained by the steps a) - e)

9. The method of claim 8 wherein said step d) of depositing a layer of ferroelectric material includes preparing a precursor for PGO by dissolving [Pb(thd)₂] and [Ge(ETO)₄], having a molar ratio of 5.0 to 5.5:3, in a mixed solvent of butyl ether or tetrahydrofuran, isopropanol and tetraglyme, in a molar ratio of 8:2:1, resulting in a precursor solutions concentration of 0.1 mole/liter of PGO;
injecting the precursor solution into a vaporizer at a temperature of between about 150°C to 250°C, at a pump at a rate of between about 0.1 ml/min. to 0.2 ml/min, to form a precursor gas; and pumping the precursor gas into a CVD chamber at a deposition temperature of between about 350°C to 450°C, at a pressure of about 5 torr, and with an oxygen partial pressure of about 30 %; and
annealing the silicon substrate in a two-step annealing process, including
first annealing step at an annealing temperature of between about 500°C to 510°C for between about 5 minutes to 10 minute in an oxygen atmosphere, using a rapid thermal processing technique; and
a second annealing step a temperature of between about 540°C to 600°C for between about 30 minutes to one hour, in an oxygen atmosphere.

10. The method of claim 8 wherein said step a) of preparing the silicon substrate includes selecting a P-type silicon substrate wafer; cleaning the P-type silicon substrate wafer and removing surface oxide from the P-type silicon substrate wafer.

11. A method of fabricating a PGO MFOS one-transistor memory device comprising:
a) preparing a silicon substrate;
b) depositing a layer of high-k insulator on the silicon substrate, including
b1) selecting a high-k material from the group of materials consisting of ZrO₂, HfO₂ and (Zrₓ,Hf₁₋ₓ)O₂,
b2) depositing the high-k material on the silicon substrate to a thickness of between about 2 nm to 20 nm, and preferably to a thickness of between about 2 nm to 8 nm; and
b3) annealing the silicon substrate at between about 500°C to 550°C in a pure oxygen atmosphere, for between about one minute and twenty minutes;
c) depositing a buffering layer on the high-k insulating layer, including selecting a buffering layer from the group of buffering layers consisting of titanium and TiO₂; and depositing the buffering layer to a thickness of between about 2 nm to 10 nm;
d) depositing a layer of ferroelectric material on the buffering layer by metal organic chemical vapor deposition, including
d1) preparing a precursor for PGO by dissolving [Pb(thd)₂] and [Ge(ETO)₄], having a molar ratio of 5.0 to 5.5:3, in a mixed solvent of butyl ether or tetrahydrofuran, isopropanol and tetraglyme, in a molar ratio of 8:2:1, resulting in a precursor solutions concentration of 0.1 mole/liter of PGO;
d2) injecting the precursor solution into a vaporizer at a temperature of between about 150°C to 250°C, at a pump at a rate of between about 0.1 ml/min. to 0.2 ml/min, to form a precursor gas; and pumping the precursor gas into a CVD chamber at a deposition temperature of between about 350°C to 450°C, at a pressure of about 5 torr, and with an oxygen partial pressure of about 30 %; and
d3) annealing the silicon substrate in a two-step annealing process, including
first annealing step at an annealing temperature of between about 500°C to 510°C for between about 5 minutes to 10 minute in an oxygen atmosphere, using a rapid thermal processing technique; and
a second annealing step a temperature of between about 540°C to 600°C for between about 30 minutes to one hour, in an oxygen atmosphere;
e) forming a top electrode on the layer of ferroelectric material; and
f) completing the device obtained by the steps a) - e)

12. The method of claim 11 wherein said step a) of preparing the silicon substrate includes selecting a P-type silicon substrate wafer; cleaning the P-type silicon substrate wafer and removing surface oxide from the P-type silicon substrate wafer.
